# EUROPEAN PATENT APPLICATION

(11) **EP 4 807 052 A1**
(43) Date of publication of application: **16.09.2026**
(21) Application number: 25163381.4
(22) Date of filing: 13.03.2025
(51) Int. Cl.: C30B 29/36, C30B 23/02

(54) **METHOD OF PROVIDING A DEFORMATION-RESISTANT SUBSTRATE, METHOD OF GROWING A LAYER USING THE DEFORMATION-RESISTANT SUBSTRATE, AND A BATCH COMPRISING A PLURALITY OF MONOCRYSTALLINE SUBSTRATES**

(71) Applicant: SiCrystal GmbH, 90411 Nürnberg (DE)
(72) Inventor: KLIETZ, Wenzel, 90411 Nürnberg (DE); VOGEL, Michael, 90411 Nürnberg (DE)
(74) Representative: Grünecker Patent- und Rechtsanwälte PartG mbB

(57) **Abstract**

The present invention relates to a method of providing a deformation-resistant substrate for growing a layer in a direction of growth (Y) in a reactor on the deformation-resistant substrate, the method comprising the steps of: measuring an internal stress value of a monocrystalline raw substrate in a radial direction (r) perpendicular to the direction of growth (Y); determining, based on the measured internal stress value, a radial size (d_substrate) for the deformation-resistant substrate in the radial direction (r) and an axial size (t_substrate) for the deformation-resistant substrate in the direction of growth (Y); and providing the deformation-resistant substrate by selecting a deformation-resistant substrate with the determined radial size (d_substrate) and the determined axial size (t_substrate).

## Description

The present invention relates to a method of providing a deformation-resistant substrate, method of growing a layer using the deformation-resistant substrate, and a batch comprising a plurality of monocrystalline substrate.

Semiconductor materials such as silicon carbide (SiC) are commonly used in the manufacture of electronic components. SiC is a compound semiconductor that forms the basis for power electronic components, e.g. in the automotive and green energy sectors.

Using a suitable source material, volume mono crystals are typically grown by sublimation growth as a physical vapor deposition (PVT) process. Substrates are then fabricated from the grown volume mono-crystals using e.g. multi-wire saws or lasers, and the surface is then refined using multi-stage polishing steps. These substrates are then used in subsequent process.

For example, in a subsequent epitaxial process, thin single crystal growing layers (e.g. SiC, GaN) are deposited on the raw substrate. Alternatively, the raw substrate may be used as a source material for growing a new volume mono crystal.

The properties of these products, e.g. the singly crystal layers or the new volume mono crystal, and the components made from them depend crucially on the quality of the substrate.

The quality of the substrate is influenced by various factors during its growth and processing. For example, metallic impurities from the crucible or the source powder can be incorporated into the crystal, affecting its electrical properties and mechanical strength. Additionally, fluctuations in temperature gradients during growth can lead to thermal stress, dislocations, or point defects in the crystal lattice. The presence of dopants (e.g., boron, phosphorus or nitrogen) also influences crystal quality by modifying electrical conductivity but may introduce strain due to differences in atomic size between dopant and silicon atoms.

Post-growth processing, such as wafer slicing, polishing, and etching, further affects crystal quality. Mechanical stress from cutting can introduce micro-cracks or residual strain, which may lead to defects during device fabrication. Surface contamination, oxidation, and chemical residues from cleaning or doping processes can also impact wafer quality, leading to defects that degrade semiconductor performance. Additionally, annealing and thermal treatments are used to relieve stress and improve crystallinity but must be carefully controlled to prevent the formation of unwanted defects such as slip dislocations. Ultimately, precise control over growth parameters, doping, and post-processing steps is essential to ensure high-quality silicon carbide crystals for semiconductor applications.

It should be noted that, for example, from the point of view of entropy and thermodynamics, a crystal lattice cannot be completely free of imperfections at any finite temperature. Entropy, which measures disorder in a system, plays a fundamental role in determining the presence of defects in a crystal. In particular, internal stress in a crystal arises from imperfections, external influences, or growth conditions that disrupt its perfect lattice structure. It can result from thermal expansion mismatches, doping-induced lattice distortions, mechanical processing (e.g., polishing or etching), or defects such as dislocations and vacancies. While an ideal monocrystal has no internal stress, real-world crystals exhibit strain.

The internal stress has an influence in subsequent processes. In the present description, the influence of the internal stress in a subsequent process for growing a layer on the substrate is considered. For example, the application of epitaxial layers can lead to mechanical stresses in the substrate-epitaxy composite. These stresses become apparent through a deformation of the substrate and, in the worst case, can mean that the substrate can no longer be handled by robotic systems in fully automated facilities. Alternatively, if the SiC substrate is used as a seed substrate for growing new volume mono crystal using the PVT method, the stresses can reduce the quality of the new volume mono crystal. In more detail, in the process of growing the new volume mono crystal, the substrates, also referred to as seeds, are firmly bonded to other materials. This composite material makes it possible for mechanical stresses to form during the growing process. These stresses become noticeable through a deformation of the seed substrate. This leads to a deterioration of the grown SiC single crystal.

In view of the above, it is an object is to increase the deformation resistance of a substrate. In particular, it is an object to reduce the influence of internal stresses, which may cause deformation in a subsequent growing process. A further object is to reduce costs, for example by providing substrates with a big diameter, e.g. a diameter of more than 150 mm, and/or substrates with a small thickness, e.g. a thickness of less than 2.5 mm.

At least one of these objects is solved by the subject matter of the independent claims. Advantageous embodiments are solved by the dependent claims.

According to a general aspect of the present disclosure it has been recognized that deformation resistance of a substrate that causes deformation in a subsequent growing process for growing a layer in a direction of growth can be described by three parameters.

In particular, a first parameter that influences the deformation resistance relates to internal stresses in the crystalline lattice such as a SiC substrate. A high internal stress reduces the deformation resistance and can lead to deformations during subsequent growing process, e.g. the epitaxy process. The deformations may be present even before growing a layer, e.g. by epitaxy. This parameter can be measured by measuring the internal stress, e.g. using techniques like X-ray diffraction, Raman spectroscopy, photo elasticity, or neutron diffraction. Further, this parameter can be measured by using neutron diffraction or photo elasticity. In general, the absolute value of the stress is used, i.e. σ. The absolute stress value can be determined based on one measurement. Further, a relative absolute stress value |Δσ| can be used. The relative absolute stress value can be determined based on two measurements and or one measurement and one assumed value.

The second parameter that influences the deformation resistance relates to the diameter of the substrate. Herein, the diameter of the substrate is a radial size determined in the radial direction, perpendicular to the direction of growth. A larger diameter reduces the deformation resistance of the substrate, which means that deformations caused by the subsequent growing process, e.g. the epitaxy process, can occur more likely and/or are stronger.

The third parameter that influences the deformation resistance relates to the thickness of the substrate. Herein, the thickness of the substrate is an axial size determined in the direction of growth. A greater thickness increases the deformation resistance, making deformations due to a subsequent process such as the epitaxy process less likely.

In view of the above, a deformation factor (DF) describing the mechanical deformation resistance can be described by Equation (1). $DF = \frac{internal stress value σ ∗ radial size}{axial size}$

As discussed above, the internal stress of the substrate is influenced by various factors. In particular, it has been observed that internal stresses are mostly related to the growth process, such as the axial and radial temperature gradients. After the growth process, they are present to a defined extent in a volume monocrystal, and thus, are also in substrates diced out of the volume monocrystal. For example, as the internal stress value the relative absolute stress value |Δσ| is measured.

Further, the diameter and the thickness of a substrate can be adjusted, for example, by dicing substrates out of one volume monocrystal and or set by setting the growth diameter.

In view of the above, according to a general aspect according to the present disclosure, an internal absolute stress value σ of a monocrystalline raw substrate is measured in a radial direction. Based on the measured internal stress value σ, a radial size and an axial size is determined. In view of the three parameters, a deformation-resistant substrate can be selected. This facilitates to react to internal stresses in the crystal and to produce substrate with adapted thicknesses and/or diameters.

In view of a compromise between economic interests and technical advantages, the DF of the selected substrate can equal to or greater than 0.03 GPa and less than or equal to 30 GPa. The substrates produced in this way facilitate that the substrates are to a certain extend resistant to deformation in subsequent growing processes such as the epitaxy processes and for example facilitates that the epitaxial substrates being handled by robotic systems in fully automated systems. Further, the costs for the substrate may be minimized by minimizing the thickness and/or maximizing the diameter.

The invention will now be described in more detail and by way of example using advantageous embodiments and with reference to the drawings. The embodiments described are only possible configurations in which the individual features described may be provided independently of one another or may be omitted.

The accompanying drawings are incorporated in and made a part of the specification to illustrate various embodiments of the present invention. These drawings, together with the specification, serve to explain the principles of the invention. The drawings are intended only to illustrate the preferred and alternative examples of how the invention may be made and used, and are not to be construed as limiting the invention to only the embodiments illustrated and described. In addition, several aspects of the embodiments, individually or in different combinations, may constitute solutions according to the present invention. Thus, the following described embodiments may be considered either alone or in any combination thereof. The described embodiments are only possible configurations and it must be kept in mind that the individual features as described above can be provided independently of each other or can be omitted altogether when implementing this invention. Further features and advantages will become apparent from the following more detailed description of the various embodiments of the invention as illustrated in the accompanying drawings, wherein like references refer to like elements and wherein:
FIG. 1 is a schematic view of a growing arrangement;
FIGS. 2 to 3 are schematic views of a substrate;
FIG. 4 is a flow diagram according to an example for providing a deformation-resistant substrate;
FIGS. 5 to 9 are details of the flow diagram of Fig. 4; and
FIG. 10 is a flow diagram according to an example for growing a layer on a deformation-resistant substrate.

This application specifically discusses a substrate in the context of SiC substrates. Other materials of substrates of monocrystalline material may be also possible. Further, the present description discussed the deformation in particular with an epitaxial growing process but other growing processes, for example growing a volume mono crystal. may be also possible.

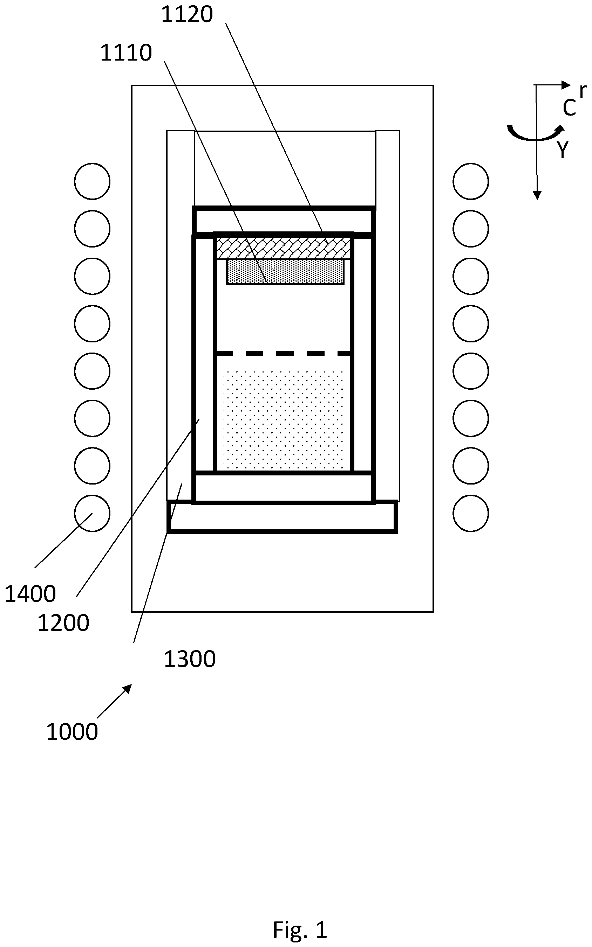

FIG. 1 shows an exemplary sublimation growth system 1000, in particular a PVT crystal growth system, carried out in a crucible 1200. A crucible is a container in which materials, e.g. SiC, can be exposed to very high temperatures (above 2000°C), e.g. a temperature that allows sublimation of SiC. In particular, the crucible is made of a material that can withstand temperatures high enough to melt and/or sublime its contents.

As shown in FIG. 1, the crucible 1200 is placed in a tubular container 1300, which may be made of quartz glass, and is surrounded by an induction heater 1400. Alternatively, the tubular container could be made of stainless steel and the heater could be a resistance heater. The parts together form a reactor, which is the core of the system 1000. The tubular container 1300 is a machine used to perform processes that require elevated temperature and pressure relative to ambient pressure and/or temperature.

The actual crystal growth takes place inside the crucible 1200. The walls of the crucible 1200 can be made of materials such as graphite and carbon. These materials allow the crucible 1200 to heat the growth material, e.g. SiC, to growth temperatures in excess of 2000°C.

In particular, for growing the SiC volume monocrystal, a SiC seed crystal 1110 is disposed on a seed holder 1120 which is disposed on an end wall of the crucible 1200 prior to the start of growth. More specifically, the SiC seed crystal 1110 is disposed in a crystal growth region of the growth crucible, which is preferably completely closed, in particular at least during growth.

Powdered SiC source material is introduced into a storage region of the growth crucible. A thick dashed line indicates a boundary of the storage region at the start of the growth process. The boundary is, for example, a wall of porous graphite. During the growth, a SiC growth gas phase is produced there by sublimation of the powdered SiC source material and by transport of the sublimated gaseous components into the crystal growth region, and the SiC volume monocrystal with a central longitudinal axis along the Y-axis grows, in particular by deposition from the SiC onto the SiC seed crystal 1110.

To grow the SiC volume monocrystal, a temperature distribution along the Y-axis is realized in the crucible. In general, the highest temperature is usually in the storage region and the seed 1110 is at a lower temperature so that the gaseous material condenses.

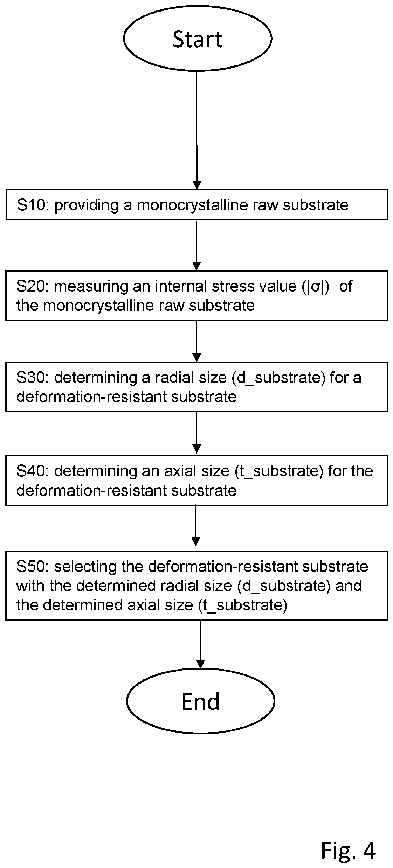

As shown in FIG. 4, heating can be provided either by induction coils 1400 located outside the tubular container 1200. In particular, the induction coils 1400 are arranged along a circumferential direction C. Alternatively, according to a solution not shown, resistance heaters can be placed inside the reactor 1300.

Induction heating is the process of heating electrically conductive materials by electromagnetic induction, by current passing through the inductor 1400, which creates an electromagnetic field within the coil to directly heat the material in the SiC storage region 1160 and/or to heat a side wall of the crucible to indirectly heat the SiC in the storage region. The side wall of the crucible extends along the circumferential direction along the growth direction, i.e., the Y axis. The insulation thermally insulates the crucible and a cavity formed inside the crucible. Notably, the above discussed metal seed holder may be heated by the induction coil, and thus, influence the temperature distribution.

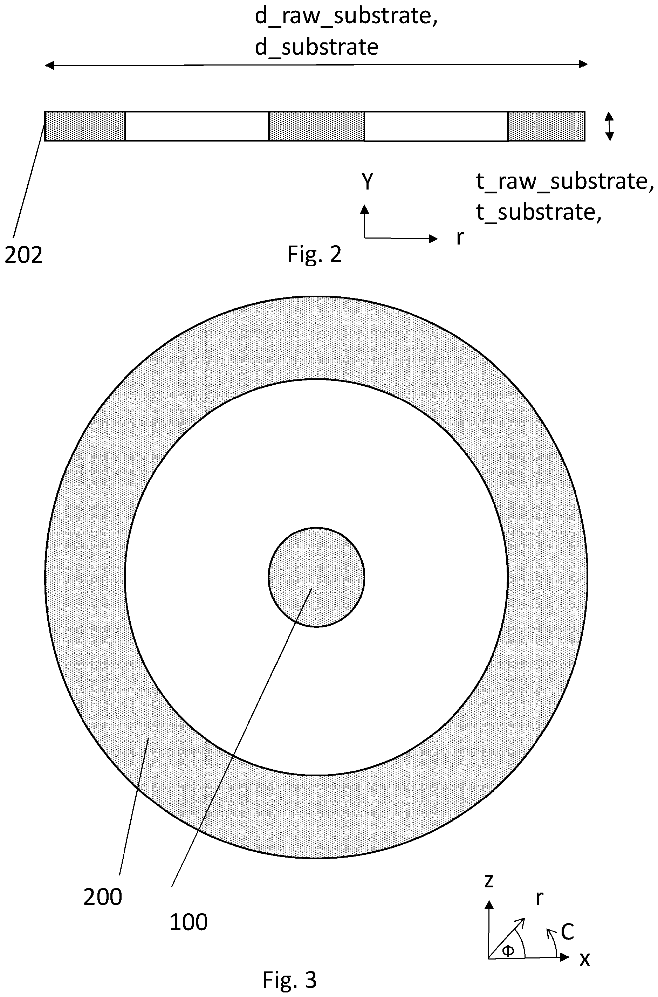

FIGS. 2 and 3 show a schematic of a monocrystalline substrate. For example, the substrate is the raw substrate, which is diced out of a volume mono crystal. The raw substrate has a radial size d_raw_substrate determined in the radial direction r and an axial size t_raw_substrate in the direction of growth Y. Alternatively, the substrate is a deformation-resistant substrate, which is diced out of a volume mono crystal or derived by reducing the raw substrate in a radial direction r and/or a direction of growth Y. The deformation-resistant substrate has a radial size d_substrate determined in the radial direction r and an axial size t_ substrate in the direction of growth Y

According to a first aspect of the present description, in particular shown in Fig. 4, a method of providing a deformation-resistant substrate for growing a layer in a direction of growth Y in a reactor, e.g. system 1000, on the deformation-resistant substrate.

As used herein, **providing** generally means making something available, supplying, or offering something, here the deformation-resistant substrate, to be used for something, here for example in growing a layer in a reactor such as the system 1000.

As used herein, **deformation-resistant** refers to a property of the substrate maintains at least one of its shape and structural integrity in a subsequent growing process. The growing process may add external influences such as mechanical stress, thermal expansion, or external forces. This qualitative description of deformation-resistant can be quantified by above discussed Equation (1). In particular, the deformation-resistant substrate may have a deformation factor (DF) of less than or equal to 30 GPa. Optionally, the DF is less than or equal to 10 GPa. According to a further option, the DF is less than or equal to 5 GPa Considering that a real crystal has a certain amount internal stress, the deformation factor of a real crystal is non-zero. It has been found out that the DF is equal to or greater than 0.03 GPa. Optionally, the DF is equal to or greater than 0.2 GPa. According to a further option, the DF is equal to or greater than 0.5 GPa.

As used herein **growing a layer** refers to the formation of layers on a growing layer of a substrate through controlled deposition or chemical reactions. In particular, growing a layer can include growing a volume mono crystal on the deformation-resistant substrate. Further, growing can include growing an epitaxial layer on the deformation-resistant substrate. In particular, the growth process comprises depositing a material onto a heated substrate. In view of the substrate being heated, considering the deformation-resistance facilitates to optimize the finalized product. The growing process is performed in a reactor such as the system described in Fig. 1 but may be any container that allows a growing process in particular under conditions allowing to heat the substrate and providing a vacuum environment.

As shown in Fig. 4, at step S10, a monocrystalline raw substrate is provided. For example, a raw substrate as discussed in Figs. 2 and 3 is provided.

According to the first aspect, as for example shown in Fig. 4 at S20, an internal stress value σ of a monocrystalline raw substrate, for example the raw substrate discussed above with reference to Figs. 2 and 3, is measured. The internal stress value σ, for example an absolute stress value σ, is measured in the radial direction r, which is perpendicular to the direction of growth Y in the subsequent growing process.

There are several methods to measure internal stress values in a monocrystalline substrate. In general, the method can categorized into X-ray, electron, and optical techniques. For example, X-ray Diffraction (XRD) methods measures stress by analyzing changes in the diffraction pattern of X-rays scattered by the crystal lattice. Raman spectroscopy measures stress by detecting shifts in the vibrational frequencies of atoms within the lattice. Photoelasticity is an experimental stress analysis technique that uses polarized light to visualize and measure stress distribution in transparent materials based on birefringence. Neutron diffraction is used for measuring stress by analyzing the changes in atomic lattice spacings within a material, as neutrons penetrate deeply and provide non-destructive, three-dimensional residual stress mapping

Measuring stress in a crystal lattice facilitates understanding material properties, failure mechanisms, and device performance. In particular, measuring the internal stress facilitates to determine further parameters for the deformation-resistant substrate in the subsequent growing process.

According to the first aspect, as for example shown in Fig. 4 at steps S30 and S40, the method comprises determining, based on the measured internal stress value σ, a radial size, which is indicated in Fig. 2 as d_substrate, for the deformation-resistant substrate in the radial direction r and an axial size, which is indicated in Fig. 2 as t_substrate, for the deformation-resistant substrate in the direction of growth Y.

As used herein, **determining** refers to finding, calculating, setting, measuring, and/or identifying at least one of the radial size and the axial size based on given conditions such as Equation (1) or predefined values.

For example, if the radial size is for example determined to be a set or measured value of for example a volume mono crystal, the radial size of the deformation-resistant substrate can be determined based on the set or measured radial size of the volume mono crystal. Further, in the example, the axial size of the deformation-resistant substrate can be determined by setting a dicing thickness based on the measured internal stress value and the derived radial size. In the example, if the measured internal stress value is low, the thickness of the substrate may be reduced.

In other words, an axial size and the radial size is determined, e.g. derived by values set or measured for the raw substrate or the deformation-resistant substrate. Further, based on the measured internal stress value, at least one of the axial size and the radial size is determined. For example, the at least one of the axial size and the radial size may be calculated based on Equation (1) using the measured internal stress value σ.

According to the first aspect, as for example shown in Fig. 4 at step S50, the deformation-resistant substrate is provided by selecting a deformation-resistant substrate with the determined radial size d_substrate and the determined axial size t_substrate. The above discussed steps in view of the first aspect, in particular measuring the internal stress, determining the axial size, and determining the radial size, facilitate providing a deformation-resistant substrate.

According to a second aspect, which is provided in addition to the first aspect, the internal stress value σ is determined based on a relative stress value Δσ between a first stress value measured at a first position in the radial direction r of the raw substrate and a second stress value measured at a second position in the radial direction r of the raw substrate. This facilities to increase the measurement accuracy compared to measuring the internal stress value only at one position.

According to an option, at least one of the first stress value and the second stress value is an average value determined based on a plurality of measurements. This facilitates to further increase the measuring accuracy.

According to a third aspect, which is provided in addition to the second aspect, which is for example shown in Fig. 3, the first position is located in a central region 100 of a growing layer of the raw substrate and the second position is an edge region 200 in the radial direction r of the raw substrate.

For example, the stress in the central region 100 is determined, i.e. measured, using one of the above discussed methods. According to an option the average stress is determined on an area in the central region 100. For example, the central region is greater than or equal to 5 % and less than or equal to 15 % of a total surface area of the raw substrate. For example, the central region corresponds to 10% of the total area of the substrate.

Before or after the measurement in the central region 100, the stress at the edge region 200 is determined. According to an option, the average stress is determined on an area at the edge region 200. For example, the edge region covers greater than or equal to 25 % and less than or equal to 35 % of the total surface area of the raw substrate. For example, the edge region corresponds to 30% of the total area of the substrate.

The central region 100 may be determined by a centroid of the surface area. The edge region 200 may comprises an edge 202 in circumferential the direction C.

According to a fourth aspect, which is provided in addition to any one of the first to third aspect, the internal stress value σ is measured using at least one of the above discussed Raman spectroscopy, X-ray diffraction, photo elasticity, and neutron diffraction.

As already discussed above, according to a fifth aspect, which is provided in addition to any one of the first to fourth aspect, the deformation-resistant substrate may have a deformation factor (DF) of a mechanical deformation resistance calculated based on the Equation (1), wherein the DF is equal to or greater than 0.03 GPa and less than or equal to 30 GPa. The equation (1) and the ranges for DF facilitate to calculate at least one of the radial size and the axial size of the deformation-resistant substrate based on the measured internal stress.

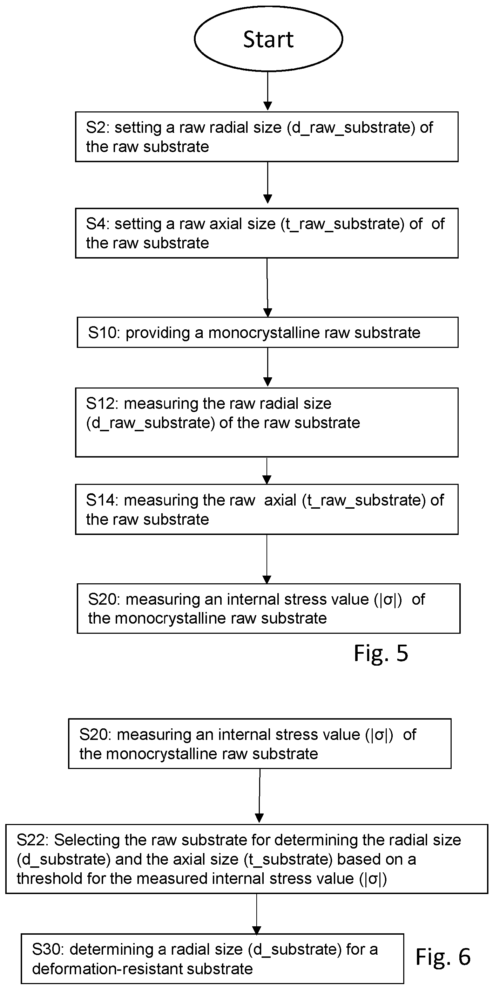

As discussed above with regard to the first aspect, determining the axial size and the radial size of the deformation-resistant substrate can be based on the raw substrate. For example, as shown with regard to Fig. 5, parameters for the raw substrate may be set in advance. Additionally or alternatively, parameters of the raw substrate may be measured. Based on this set or measured values for the raw substrate, the deformation-resistant substrate can be selected. Fig. 5 shows details before S20 of Fig. 4. In other words, is possible to adjust the thickness or diameter and thus set the desired deformation factor defined in Equation (1). It is also possible to set the deformation factor by adjusting the diameter and the thickness.

In more detail, according to a sixth aspect, which is provided in addition to any one of the first to fifth aspect, the method comprises in a step S2 shown in Fig. 5, setting a raw radial size d_raw_substrate of the raw substrate to a predefined diameter value, optionally wherein the predefined diameter value is equal to or greater than 150 mm and less than or equal to 300 mm. Based on this set value for the raw substrate, the radial size of deformation-resistant substrate can be determined. For example, it can be derived that the deformation-resistant substrate has a diameter value of equal to or greater than 150 mm and less than or equal to 300 mm.

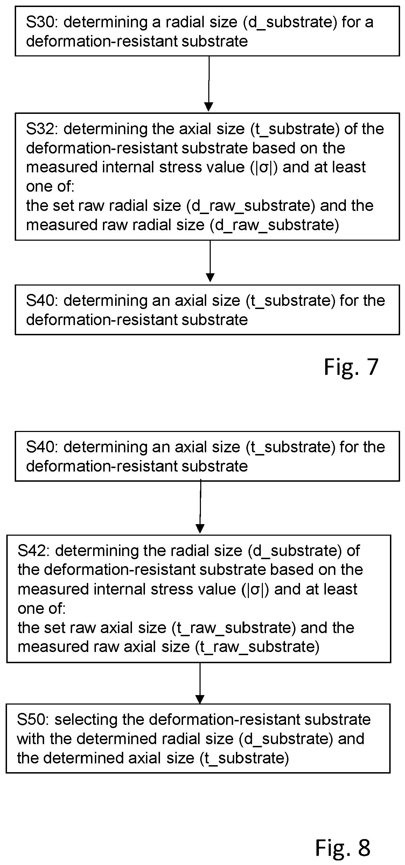

According to an option of the sixth aspect as shown in Fig. 7 at S32, the axial size t_substrate of the deformation-resistant substrate is determined, e.g. calculated by Equation (1), based on the set raw radial size d_raw_substrate and the measured internal stress value σ.

According to a seventh aspect, which is provided in addition to any one of the first to sixth aspect, the method comprises in step S4 shown in Fig. 5 setting a raw axial size t_raw_substrate of the raw substrate to a predefined thickness value, optionally wherein the predefined thickness value is equal to or greater than 0.2 mm and less than or equal to 2.5 mm. Based on this set value for the raw substrate, the axial size of deformation-resistant substrate can be determined. For example, it can be derived that the deformation-resistant substrate has a thickness value of equal to or greater than 0.2 mm and less than or equal to 2.5 mm.

According to an option of the seventh aspect as shown in Fig. 8 at S42, the axial size t_substrate of the deformation-resistant substrate is determined, e.g. calculated by Equation (1), based on the set raw radial size d_raw_substrate and the measured internal stress value σ.

Further, according to an eight aspect, which is provided in addition to any one of the first to seventh aspect, the method comprises in a step S12 shown in Fig. 5, measuring a raw axial size t_raw_substrate of the raw substrate. Based on this measured value for the raw substrate, the radial size of deformation-resistant substrate can be determined. For example, it can be selected that the deformation-resistant substrate has a diameter value of equal to or greater than 150 mm and less than or equal to 300 mm.

According to an option of the eighth aspect as shown in Fig. 7 at S32, the axial size t_substrate of the deformation-resistant substrate is determined, e.g. calculated by Equation (1), based on the measured raw radial size d_raw_substrate and the measured internal stress value σ.

Further, according to a ninth aspect, which is provided in addition to any one of the first to eighth aspect, the method comprises in a step S14 shown in Fig. 5, measuring a raw radial size t_raw_substrate of the raw substrate. Based on this measured value for the raw substrate, the radial size of deformation-resistant substrate can be determined. For example, it can be selected that the deformation-resistant substrate has a thickness value of equal to or greater than 0.2 mm and less than or equal to 2.5 mm.

According to an option of the ninth aspect as shown in Fig. 8 at S42, the radial size r_substrate of the deformation-resistant substrate is determined, e.g. calculated by Equation (1), based on the measured raw axial size t_raw_substrate and the measured internal stress value σ.

As discussed in particular with regard to the sixth to ninth aspect, it is possible to determine the radial size and/or the axial size based on the raw substrate. Based on a desired deformation factor, which may be defined according to Equation (1), at least one of the radial size and the axial size may be adjusted. The following tenth to twelfth aspects describe the possibilities of how to adjust at least one of the radial size and the axial size.

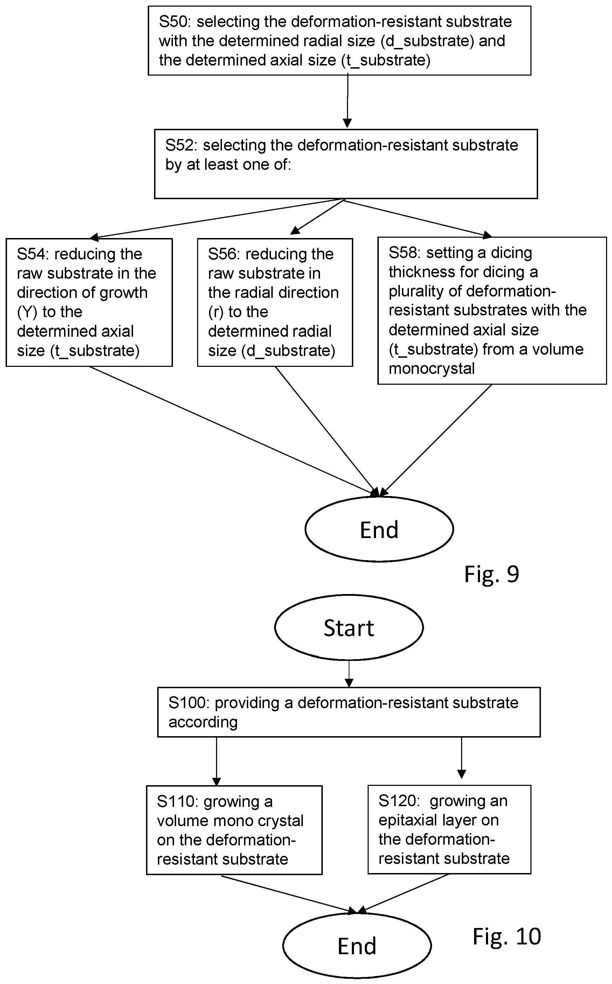

According to a tenth aspect, which is provided in addition to any one of the first to ninth aspect, the method may further comprise, as example shown in Fig. 9, selecting in S52 the deformation-resistant substrate by reducing in S54 a substrate, e.g. the raw substrate, in the direction of growth Y to the determined axial size. In other words, the raw substrate is machined, e.g. by polishing or etching, to the determined axial size.

According to an eleventh aspect, which is provided in addition to any one of the first to tenth aspect, the method may further comprise, as example shown in Fig. 9, selecting inS52 the deformation-resistant substrate by reducing in S54 a substrate, e.g. the raw substrate, in the radial direction r to the determined radial size. In other words, the raw substrate is machined, e.g. by polishing or etching, to the determined radial size.

According to a twelfth aspect, which is provided in addition to any one of the first to the eleventh aspect, the method may further comprises, as for example shown in Fig. 9, setting in S58 a dicing thickness for dicing a plurality of deformation-resistant substrates with the determined axial size from a volume monocrystal. In other words, a way to adjust the deformation factor is to separate a raw substrate from a volume mono crystal and determine the internal stresses in it. The thickness for other substrates to be separated from the same volume mono crystal or from a volume mono crystal grown under similar condition, e.g. using the same reactor, can then be determined in order to dicing substrates out of volume mono crystal grown having a deformation factor that is within predetermined ranges, for example the ranges defined in the fifth aspect. These substrates may be further reduced as discussed in the tenth or eleventh aspect.

According to a thirteenth aspect, which is provided in addition to any one of the first to twelfth aspect, the method further comprises, as for example shown in Fig. 6 at S22, the step of selecting the raw substrate for determining the radial size d_substrate and the axial size t_substrate based on a threshold for the measured internal stress value σ, optionally wherein the raw substrates are selected for adjustment if the internal stress value σ is equal to or less than 20 MP. Thus, it is facilitated that the substrate is not too thick in the axial direction and/or to small in the radial direction. Additionally or alternatively, raw substrates are selected for adjustment if the internal stress value σ is equal to or greater than 0.5 MP.

The following table 1 summarizes examples of values for deformation-resistant substrates. In particular, the deformation factor is calculated according to Equation (1).

**Table 1**

| | | | | | | |
|---|---|---|---|---|---|---|
| radial size, d_substrate [mm] | 150 | 300 | 200 | 200 | 200 | 150 |
| axial size, t_substrate [µm] | 2500 | 200 | 500 | 350 | 350 | 250 |
| internal stress value σ [MPa] | 0.5 | 20 | 15.4 | 0.5 | 4 | 1 |
| deformation factor (DF) [GPa] | 0.03 | 30 | 6.16 | 0.29 | 2.29 | 0.6 |

A fourteenth aspect relates to a method of growing a layer in a direction of growth Y in a reactor on a deformation-resistant substrate. The method is for example shown in Fig. 10 and comprises the step of providing in S100 a deformation-resistant substrate according to any of aspects 1 to 13. As shown in Fig. 10, the method then comprises in step S110 growing a volume mono crystal on the deformation-resistant substrate. Alternatively, the method then comprises in step S120 growing an epitaxial layer on the deformation-resistant substrate.

A fifteenth aspect relates to a batch of monocrystalline substrates, each substrate for growing a growing layer in a direction of growth Y in a reactor and each substrate comprising a growing surface for growing the growing layer with a radial size d_substrate in a radial direction r perpendicular to the direction of growth Y and an axial size t_substrate in the direction of growth Y.

The batch according to the fifteenth aspect comprises at least two substrates, wherein the two substrates of the batch are different in at least one of the radial size and the axial size, wherein each of the substrates has a deformation factor (DF) of a mechanical deformation resistance calculated based on the Equation (1), wherein the DF is equal to or greater than 0.03 GPa and less than or equal to 30 GPa. Optionally, the DF is equal to or greater than 0.2 GPa and less than or equal to 10 GP. Optionally the DF is equal to or greater than 0.5 GPa and less than or equal to 5 GPa.

In particular, the substrates according to the fifteenth aspect is provided according to any of the first to any of aspects 1 to 13. For a description of features of the fifteenth aspect is referred to the above description of aspects 1 to 14. A batch of substrates refers to a group of substrates, for example wafers, that undergo processing together in a fabrication facility. These substrates are uniform in the specification of the DF and are manufactured together, for example diced out of one crystal or a plurality of crystals grown under similar conditions. This combined manufacturing facilitates consistency. Processing substrates in batches facilitates increasing efficiency, maintaining quality control, and ensuring uniform electrical and physical properties across all substrates in the batch. The batch according to the fifteenth aspect comprises two substrates that are different in axial size and/or radial size. The batch according to the fifteenth aspect comprises substrate that have a DF in a predefined range. Such a batch facilitates to react to internal stresses in the crystal and to produce substrates with adapted thicknesses and/or diameters. Each substrate selected according to the method according to any of the first to thirteenth aspect or each substrate of the batch is resistant to deformation in subsequent processes such as epidictic processes. Further, a substrate with a layer grown on according to the fourteenth aspect facilitates that after the subsequent process the substrates to be handled by robotic systems in fully automated systems because the deformations are kept to a minimum.

For example, the batch comprises a first substrate with a first radial size and a second substrate with a second radial size, wherein the second radial size is less than the first radial size. For example, the first substrate has the a first radial size of for example 200 mm and the second substrate has a second radial size of 199 mm so that both substrates have a DF that is equal to or greater than 0.03 GPa and less than or equal to 30 GPa. For example, the difference in radial size Δd_substrate in a batch is equal to or greater than 10 µm and/or less than or equal to 5 mm. Optionally, the difference in radial size Δd_substrate in a batch is equal to or greater than 50 µm and/or less than or equal to 1 mm.

According to an additional or alternative example, the batch comprises a first substrate with a first axial size and a second substrate with a second axial size, wherein the second axial size is less than the first axial size. For example, the first substrate has the a first axial size of for example 2000 µm and the second substrate has a second axial size of 2060 µm so that both substrates have a DF that is equal to or greater than 0.03 GPa and less than or equal to 30 GPa.

For example, the difference in axial size Δt_substrate in a batch is equal to or greater than 0.5 µm and/or less than or equal to 500 µm. Optionally, the difference in axial size Δt_substrate in a batch is equal to or greater than 1 µm and/or less than or equal to 100 µm.

Optionally, the difference in axial size Δt_substrate between two substrates in a batch is greater than 50 µm. In addition, the difference in axial size Δt_substrate in a batch is less than 500 µm.

Optionally, the difference in axial size Δt_substrate between two substrates in a batch is greater than or equal to 60 µm. Additionally, the difference in axial size Δt_substrate in the batch is less than 500 µm. Optionally, the difference in axial size Δt_substrate in the batch is less than 200 µm.

Optionally, the difference in axial size Δt_substrate between two substrates in a batch is greater than or equal to 100 µm. Additionally, the difference in axial size Δt_substrate in a batch is less than 500 µm.

Additionally or alternatively, the batch comprises a plurality of more than two substrates. The number of the substrates in a batch may referred to as n, which is a natural number. Optionally, n may be greater than or equal to 3 and/or less than or equal to 100. Optionally, n may be greater than or equal to 10 and/or less than or equal to 100. Optionally, n may be greater than or equal to 50 and/or less than or equal to 200. The thickness of the n^{th} the substrates may be defined by a linear relationship such as shown in Equation (2): ${t}_{substrate} \left(n\right) = n ∗ Δt _ substrate + t _ {substrate}_{{0}_{}}$

For example t_substrate₀ may be the above discussed wafer thickness by a customer. Further, Δt_substrate may be any of the above discussed values, in particular, Δt_substrate in a batch is equal to or greater than 0.5 µm and less than or equal to 50 µm. The value of Δt_substrate may depend of parameters of a volume mono crystal. In particular, for a volume mono crystal with low internal stress, a lower value for Δt_substrate may be selected.

## Claims

1. A method of providing a deformation-resistant substrate for growing a layer in a direction of growth (Y) in a reactor on the deformation-resistant substrate, the method comprising the steps of:
measuring an internal stress value of a monocrystalline raw substrate in a radial direction (r) perpendicular to the direction of growth (Y);
determining, based on the measured internal stress value, a radial size (d_substrate) for the deformation-resistant substrate in the radial direction (r) and an axial size (t_substrate) for the deformation-resistant substrate in the direction of growth (Y); and
providing the deformation-resistant substrate by selecting a deformation-resistant substrate with the determined radial size (d_substrate) and the determined axial size (t_substrate).

2. The method according to claim 1, wherein
the internal stress value is determined based on a relative stress value between a first stress value measured at a first position in the radial direction (r) of the raw substrate and a second stress value measured at a second position in the radial direction (r) of the raw substrate,
optionally wherein at least one of the first stress value and the second stress value is an average value determined based on a plurality of measurements.

3. The method according to claim 2, wherein
the first position is located in a central region (100) of a growing layer the of the raw substrate and the second position is an edge region (200) in the radial direction (r) of the raw substrate,
optionally wherein the central region is greater than or equal to 5 % and less than or equal to 15 % of a total surface area of the raw substrate and/or wherein the edge region covers greater than or equal to 25 % and less than or equal to 35 % of the total surface area of the raw substrate.

4. The method according to any one of claims 1 to 3, wherein
the internal stress value is measured using at least one of Raman spectroscopy, X-ray diffraction, photo elasticity, and neutron diffraction.

5. The method according to any one of claims 1 to 4, wherein
the deformation-resistant substrate has a deformation factor, DF, of a mechanical deformation resistance calculated based on the Equation $DF = \frac{internal stress value ∗ radial size \left(d_substrate\right)}{axial size \left(t_substrate\right)}$
wherein the DF is equal to or greater than 0.03 GPa and less than or equal to 30 GPa,
optionally the DF is equal to or greater than 0.2 GPa and less than or equal to 10 GPa;
optionally the DF is equal to or greater than 0.5 GPa and less than or equal to 5 GPa.

6. The method according to any of claims 1 to 5, wherein the method further comprises the step of
setting a raw radial size (d_raw_substrate) of the raw substrate to a predefined diameter value, optionally wherein the predefined diameter value is equal to or greater than 150 mm and less than or equal to 300 mm;
optionally wherein the determined axial size (t_substrate) of the deformation-resistant substrate is determined based on the set raw radial size (d_raw_substrate) and the measured internal stress value.

7. The method according to any of claims 1 to 6, wherein the method further comprises the step of
setting a raw axial size (t_raw_substrate) of the raw substrate to a predefined thickness value, optionally wherein the predefined thickness value is equal to or greater than 0.2 mm and less than or equal to 2.5 mm;
optionally wherein the determined radial size (d_substrate) of the deformation-resistant substrate is determined based on the set raw axial size (t_raw_substrate) and the measured internal stress value.

8. The method according to any one of claims 1 to 7, wherein the method further comprises the step of :
measuring a raw radial size (d_raw_substrate) of the raw substrate;
optionally wherein the determined axial size (t_substrate) of the deformation-resistant substrate is determined based on the measured raw radial size (d_raw_substrate) and the measured internal stress value.

9. The method according to any of claims 1 to 8, wherein the method further comprises the step of:
measuring a raw axial size (t_raw_substrate) of the raw substrate;
optionally wherein the determined radial size (d_substrate) of the deformation-resistant substrate is determined based on the measured raw axial size (t_raw_substrate) and the measured internal stress value.

10. The method according to any one of claims 1 to 9, wherein the method further comprises the step of:
selecting the deformation-resistant substrate by reducing the raw substrate in the direction of growth (Y) to the determined axial size (t_substrate).

11. The method according to any one of claims 1 to 10, wherein the method further comprises the step of:
selecting the deformation-resistant substrate by reducing the raw substrate in the radial direction (r) to the determined radial size (d_substrate).

12. The method according to any of claims 1 to 11, wherein the method further comprises the step of:
setting a dicing thickness for dicing a plurality of deformation-resistant substrates with the determined axial size (t_substrate) from a volume monocrystal.

13. The method according to any of claims 1 to 12, wherein the method further comprises the step of
selecting the raw substrate for determining the radial size (d_substrate) and the axial size (t_substrate) based on a threshold for the measured internal stress value, optionally wherein raw substrates are selected for adjustment if the internal stress value is equal to or less than 20 MP,
optionally where in the raw substrates are selected for adjustment if the internal stress value is equal to or greater than 0.5 MP.

14. A method of growing a layer in a direction of growth (Y) in a reactor on a deformation-resistant substrate, the method comprising the steps of:
providing a deformation-resistant substrate according to any of claims 1 to 13;
growing a volume mono crystal on the deformation-resistant substrate; or
growing an epitaxial layer on the deformation-resistant substrate.

15. A batch of monocrystalline substrates, each substrate for growing a growing layer in a direction of growth (Y) in a reactor and each substrate comprising:
a growing surface for growing the growing layer with a radial size (d_substrate) in a radial direction (r) perpendicular to the direction of growth (Y);
an axial size (t_substrate) in the direction of growth (Y);
the batch comprising at least two substrates, wherein the two substrates of the batch are different in at least one of the radial size and the axial size,
wherein each of the substrates has a deformation factor, DF, of a mechanical deformation resistance calculated based on the Equation: $DF = \frac{internal stress value ∗ radial size \left(d_substrate\right)}{axial size \left(t_substrate\right)}$ wherein the DF is equal to or greater than 0.03 GPa and less than or equal to 30 GPa.
